## Europäisches Patentamt
## European Patent Office
## Office européen des brevets

(11) Veröffentlichungsnummer: **0 280 908 B1**

# EUROPÄISCHE PATENTSCHRIFT

(45) Veröffentlichungstag der Patentschrift: **12.06.91**

(51) Int. Cl.⁵: **G01R 33/34**

(21) Anmeldenummer: **88101633.1**

(22) Anmeldetag: **04.02.88**

(54) Oberflächenspule für ein Kernspin-Resonanzgerät.

(30) Priorität: **17.02.87 DE 3704996**

(43) Veröffentlichungstag der Anmeldung:
**07.09.88 Patentblatt 88/36**

(45) Bekanntmachung des Hinweises auf die
Patenterteilung:
**12.06.91 Patentblatt 91/24**

(84) Benannte Vertragsstaaten:
**DE GB NL**

(56) Entgegenhaltungen:
**EP-A- 0 171 741**
**EP-A- 0 175 129**
**WO-A-84/00214**
**DE-A- 3 323 657**
**GB-A- 2 159 626**

(73) Patentinhaber: **Siemens Aktiengesellschaft**
**Wittelsbacherplatz 2**
**W-8000 München 2(DE)**

(72) Erfinder: **Krause, Norbert, Dr.**
**Weinbergstrasse 29**
**W-8551 Heroldsbach(DE)**
Erfinder: **Requardt, Hermann, Dr.**
**Hofmannstrasse 107**
**W-8520 Erlangen(DE)**

Rank Xerox (UK) Business Services

## Beschreibung

Die Erfindung betrifft eine Oberflächenspule für ein KernspinResonanzgerät zur Ermittlung von Spektren oder Bildern eines Untersuchungsobjektes mittels der kernmagnetischen Resonanz mit Spulen zum Anlegen von magnetischen Grund- und Gradientenfeldern an das Untersuchungsobjekt und mit einer Antenne, mit der das Untersuchungsobjekt mit einer Folge von Hochfrequenzimpulsen bestrahlt wird, wobei die vom Untersuchungsobjekt ausgesandten Kernresonanzsignale mit der Oberflächenspule erfaßt werden und wobei die Oberflächenspule über eine Abstimmeinheit an eine Auswerteschaltung angeschlossen ist.

Eine solche Oberflächenspule ist beispielsweise aus der Patentanmeldung WO 84/00 214 oder z.B. auch aus EP-A-0 175 129 bekannt.

Oberflächenspulen werden in der Kernspin-Tomographie und in der Kernspin-Spektroskopie verwendet, wenn bestimmte Teile des Untersuchungsobjektes mit verbessertem Signal-Rausch-Verhältnis ausgewertet werden sollen. Speziell in der Wirbelsäulendiagnostik mußte bisher beim Einsatz von Oberflächenspulen stets ein Kompromiß eingegangen werden. Große (ovale) Oberflächenspulen ermöglichen zwar ein großes Meßfeld bei hoher Eindringtiefe. Entsprechend der großen Fläche wird aber auch das Signal-Rausch-Verhältnis (SNR) schlecht. Kleine (im allgemeinen runde) Oberflächenspulen haben zwar ein günstiges Signal-Rausch-Verhältnis, sie weisen jedoch nur ein kleines Meßfeld und eine geringe Eindringtiefe auf.

Um mit kleinen Oberflächenspulen bei günstigem Signal-Rausch-Verhältnis einen größeren zu untersuchenden Bereich zu erfassen, könnte man daran denken, die Oberflächenspule relativ zum Untersuchungsobjekt zu verschieben. Da die Oberflächenspulen für die Wirbelsäulendiagnostik im allgemeinen im Liegekissen eingebettet werden, gestaltet sich dies praktisch sehr schwierig.

In der Praxis wurde daher zunächst mit einer großen Oberflächenspule der kritische Bereich lokalisiert. Dann mußte der Patient umgebettet werden auf ein Liegekissen mit einer kleinen, hoch auflösenden Oberflächenspule. Dabei wurden neue Justiermaßnahmen notwendig. Dieses Verfahren ist somit recht zeitraubend und insbesondere für Patienten mit Wirbelsäulenschäden sehr unangenehm.

Aufgabe der Erfindung ist es daher, eine Oberflächenspule so auszuführen, daß sie universell einsetzbar ist.

Diese Aufgabe wird erfindungsgemäß dadurch gelöst, daß die Oberflächenspule aus mehreren Leiterabschnitten besteht, die über Schalter so miteinander und mit der Abstimmeinheit verbindbar sind, daß die je nach Stellung der Schalter mit der Abstimmeinheit verbundenen Leiterabschnitte unterschiedliche Flächen einschließen. Damit kann die wirksame Fläche der Oberflächenspule durch entsprechende Stellung der Schalter an die jeweiligen Erfordernisse (großer Untersuchungsbereich bei geringerer Auflösung oder kleiner Untersuchungsbereich bei höherer Auflösung) angepaßt werden. Außerdem kann die Lage des Untersuchungsbereiches verändert werden.

Vorteilhafte Ausgestaltungen des Erfindungsgedankens sind in den abhängigen Ansprüchen angegeben.

Ausführungsbeispiele der Erfindung werden nachfolgend anhand der FIG 1 bis 3 näher erläutert.

FIG 1    zeigt schematisch den Aufbau eines Kernspin-Resonanzgerätes,

FIG 2    zeigt ein erstes Ausführungsbeispiel der erfindungsgemäßen Oberflächenspule,

FIG 3    zeigt ein zweites Ausführungsbeispiel der erfindungsgemäßen Oberflächenspule.

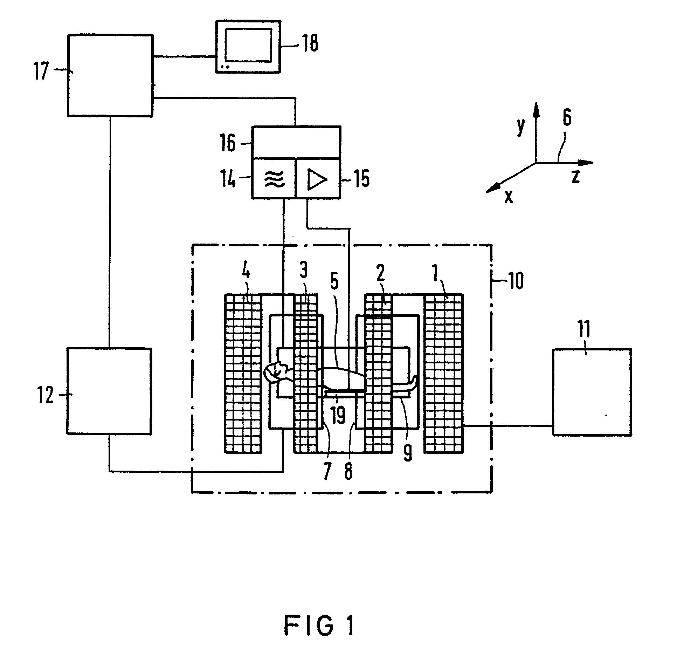

Bei dem in FIG 1 dargestellten prinzipiellen Aufbau eines Kernspin-Resonanzgerätes zur Ermittlung von Bildern oder Spektren eines Untersuchungsobjektes sind mit 1 und 2 sowie 3 und 4 Spulen bezeichnet, die ein magnetisches Grundfeld $B_0$ erzeugen, in welchem sich bei medizinischer Anwendung der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x,y und z gemäß dem Koordinatenkreuz 6 vorgesehen sind. In FIG 1 sind der Übersichtlichkeit halber nur die Gradientenspulen 7 und 8 gezeichnet, die zusammen mit einem Paar gegenüberliegender, gleichartiger Gradientenspulen zur Erzeugung eines Gradienten in x-Richtung dienen. Die gleichartigen, nicht gezeichneten Gradientenspulen zur Erzeugung eines Gradienten in y-Richtung liegen parallel zum Körper 5 und oberhalb sowie unterhalb von ihm, die Gradientenspulen für das Gradientenfeld in z-Richtung liegen quer zu seiner Längsachse am Fuß- und am Kopfende. Die Anordnung enthält außerdem noch einen zur Erzeugung der Kernresonanzsignale dienenden Körper-Resonator 9 als Antenne. Zur Aufnahme der Kernresonanzsignale ist eine Oberflächenspule 19 vorgesehen, die alternativ zum Körperresonator 9 auch zur Erzeugung der Kernresonanzsignale dienen kann.

Das eigentliche Untersuchungsinstrument besteht aus den von einer strichpunktierten Linie 10 umgrenzten Spulen 1,2,3,4,7 und 8 sowie dem Körperresonator 9 und der Oberflächenspule 19. Zum Betrieb der Spulen 1 bis 4 ist ein Netzgerät 11 vorgesehen. An einer Gradientenstromversorgung 12 liegen die Gradientenspulen 7 und 8 sowie weitere, nicht dargestellte Gradientenspulen an. Ein von einem Prozeßrechner 17 gesteuerter Hochfrequenzsender 14 ist mit dem Körperresonator 9 verbunden. Die Oberflächenspule 19 ist über einen Signalverstärker 15 ebenfalls an den Prozeßrechner 17 gekoppelt, an dem zur Ausgabe eines Bildes ein Bildschirmgerät 18 angeschlossen ist. Die Komponenten 14 und 15 bilden eine Hochfrequenzeinrichtung 16 zur Signalerzeugung und -aufnahme.

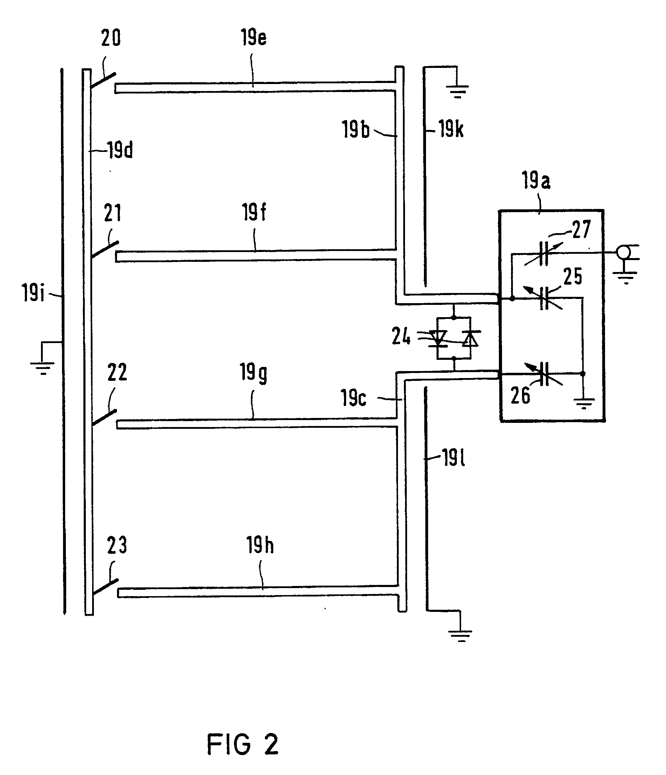

FIG 2 zeigt ein Ausführungsbeispiel der erfindungsgemäßen Oberflächenspule. An eine Abstimmeinheit 19a sind zwei in einer Linie liegende, symmetrisch zur Abstimmeinheit 19 a angeordnete erste Leiterabschnitte 19b, 19c angeschlossen. Parallel zu den Leiterabschnitten 19b und 19c ist ein zweiter Leiterabschnitt 19d vorgesehen. Zwischen den ersten Leiterabschnitten 19b, 19c und dem zweiten Leiterabschnitt 19e sind vier Brücken 19e bis 19h als dritte Leiterabschnitte vorgesehen, wobei die Leiterabschnitte 19e und 19f einerseits fest mit dem Leiterabschnitt 19b und andererseits über je einen Schalter 20 bzw. 21 mit dem Leiterabschnitt 19d verbunden sind. Die Leiterabschnitte 19g und 19h sind einerseits fest mit dem Leiterabschnitt 19c und andererseits über Schalter 22 und 23 mit dem Leiterabschnitt 19d verbunden. Parallel zum Leiterabschnitt 19d liegt eine mit Masse verbundene Abschirmleitung 19i und parallel zu den Leiterabschnitten 19b und 19c liegen ebenfalls mit Masse verbundene Abschirmleitungen 19k und 19l. Die Leiterabschnitte können beispielsweise aus Kupfer-Rohr bestehen.

Wenn man bei der dargestellten Anordnung die Schalter 20 und 23 schließt, so erhält man eine große Oberflächenspule, die zwar nur eine begrenzte Auflösung hat, dafür aber einen großen Bereich des Untersuchungsobjektes erfaßt. Einen kleineren Untersuchungsbereich mit höherer Auflösung erhält man, wenn man die Schalter 21 und 22 schließt. Durch Schließen der Schalter 20 und 22 bzw. 21 und 23 erhält man eine Oberflächenspule mittlerer Größe, deren Lage - je nachdem, ob die Schalter 20 und 22 oder 21 und 23 geschlossen sind - veränderbar ist.

Die Schalter 20 bis 23 können beispielsweise mechanische Schalter oder elektrische Schalter sein. Als elektrische Schalter bieten sich die für Hochfrequenz besonders geeigneten sogenannten Pin-Dioden-Schalter an. Durch Öffnen der Schalter 20 bis 23 kann die gesamte Oberflächenspule auch unwirksam geschaltet und somit vom Körperresonator 9 entkoppelt werden.

Die jeweils geschaltete Konfiguration der Oberflächenspule wird mit den Kondensatoren 25 und 26, die die Leiterabschnitte 19b bzw. 19c mit Bezugspotential verbinden sowie einem in Serie in die Zuleitung geschalteten Kondensator 27 auf Resonanz und Anpassung an den Leitungswiderstand der Zuleitung abgestimmt. Das Signal wird am Leiterabschnitt 19b über den abstimmbaren Kondensator 27 abgegriffen.

Zum Schutz gegen Überspannungen ist zwischen den beiden Leiterabschnitten 19b und 19c die Antiparallelschaltung 24 zweier Dioden vorgesehen.

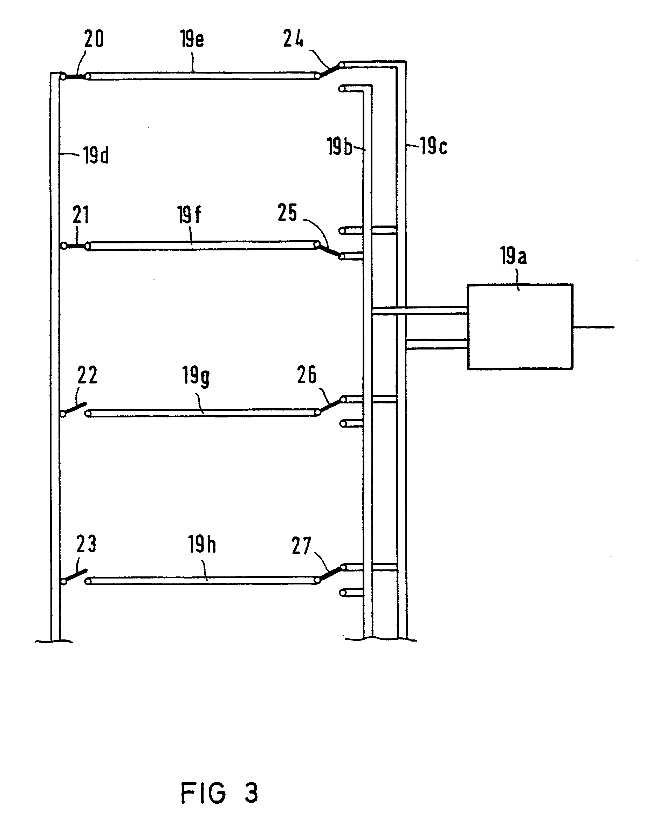

FIG 3 zeigt ein zweites Ausführungsbeispiel der Erfindung. Im Unterschied zum Ausführungsbeispiel nach FIG 1 sind dabei die beiden ersten Leiterabschnitte 19b und 19c, die jeweils an einen Anschluß der Abstimmeinheit 19a angeschlossen sind, zueinander parallel geführt. Die dritten Leiterabschnitte 19e bis 19h sind wie beim Ausführungsbeispiel nach FIG 2 einerseits über je einen Schalter 20-23 an den zweiten Leiterabschnitt 19d angeschlossen. Die andere Seite jedes dritten Leiterabschnittes 19e-19h ist über je einen Umschalter 24-27 wahlweise mit dem Leiterabschnitt 19b oder mit dem Leiterabschnitt 19c verbindbar.

Diese Anordnung hat den Vorteil, daß nicht nur die wirksame Größe der Oberflächenspule, sondern auch deren Lage zwischen den einzelnen dritten Leiterabschnitten verändert werden kann. Bei der in FIG 3 dargestellten Stellung der Schalter 20,21,24 und 25 bilden beispielsweise die Leiterabschnitte 19e und 19f sowie Teile der Leiterabschnitte 19d und 19c die Oberflächenspule. Die Lage des jeweils wirksamen Teils und damit des Untersuchungsbereichs kann zwischen den dritten Leiterabschnitten 19e bis 19h durch entsprechende Stellung der Schalter 20-27 beliebig verschoben werden, so daß z.B. unterschiedliche Bereiche der Wirbelsäule nacheinander ohne mechanische Verschiebung der Oberflächenspule untersucht werden können. Der wirksame Teil der Oberflächenspule umfaßt dabei jeweils nur eine kleine Fläche, so daß eine hohe Auflösung erzielt wird. Durch entsprechende Stellung der Schalter 22-27 ist es auch möglich, einen größeren Untersuchungsbereich mit einer Aufnahme zu erfassen, um beispielsweise das Problemgebiet einzugrenzen und dieses dann in einem nächsten Schritt mit höherer Auflösung zu untersuchen.

Selbstverständlich kann die Zahl der dritten Leiterabschnitte 19e-19h entsprechend der Länge des gesamten gewünschten Untersuchungsbereichs und der gewünschten Auflösung angepaßt werden.

**Ansprüche**

1. Oberflächenspule für ein Kernspin-Resonanzgerät zur Ermittlung von Spektren oder Bildern eines Untersuchungsobjektes mittels der kernmagnetischen Resonanz mit Spulen (1,2,3,4,7,8) zum Anlegen von magnetischen Grund- und Gradientenfeldern an das Untersuchungsobjekt (5) und mit einer Antenne (9), mit der das Untersuchungsobjekt (5) mit einer Folge von Hochfrequenzimpulsen bestrahlt wird, wobei die vom Untersuchungsobjekt (5) ausgesandten Kernresonanzsignale mit der Oberflächenspule (19), die aus mehreren Leiterabschnitten (19b - 19h) besteht, erfaßt werden und wobei die Oberflächenspule (19) über eine Abstimmeinheit (19a) an eine Auswerteschaltung angeschlossen ist, **dadurch gekennzeichnet,** daß die Leiterabschnitte (19b - 19h) der Oberflächenspule (19) über Schalter (20 - 23) so miteinander und mit der Abstimmeinheit (19a) verbindbar sind, daß die je nach Stellung der Schalter (20 - 23) mit der Abstimmeinheit (19a) verbundenen Leiterabschnitte (19b - 19h) unterschiedliche Flächen einschließen.

2. Oberflächenspule nach Anspruch 1,
   **dadurch gekennzeichnet,**
   daß die Leiterabschnitte (19b - 19h) mehrere zusammenhängende Rechtecke einschließen.

3. Oberflächenspule nach Anspruch 2,
   **dadurch gekennzeichnet,**
   daß sie aus zwei in einer Linie angeordneten ersten Leiterabschnitten (19b, 19c) besteht, die an je einen Anschluß der Abstimmeinheit (19a) angeschlossen sind,
   daß parallel zu den beiden ersten Leiterabschnitten (19b, 19c) ein zweiter Leiterabschnitt (19d) angeordnet ist und daß die beiden ersten Leiterabschnitte (19b, 19c) über mit Schaltern versehene, in Abstand zueinander parallel angeordnete dritte Leiterabschnitte (19e - 19h) mit dem zweiten Leiterabschnitt (19d) verbunden sind.

4. Oberflächenspule nach Anspruch 1 oder 2,
   **dadurch gekennzeichnet,**
   daß sie zwei zueinander parallele erste Leiterabschnitte (19b,19c) aufweist, die je an einen Anschluß der Abstimmeinheit (19a) angeschlossen sind, daß parallel zu den beiden ersten Leiterabschnitten (19b,19c) ein zweiter Leiterabschnitt (19d) angeordnet ist, daß zwischen den ersten Leiterabschnitten (19b, 19c) und dem zweiten Leiterabschnitt (19d) in Abstand zueinander parallel angeordnete dritte Leiterabschnitte (19e - 19h) vorgesehen sind, die einerseits über je einen Schalter (20 - 23) mit dem zweiten Leiterabschnitt (19d) und andererseits über je einen Umschalter (24 - 27) wahlweise mit einem der ersten Leiterabschnitte (19b,19c) verbindbar sind.

5. Oberflächenspule nach einem der Ansprüche 1 bis 4,
   **dadurch gekennzeichnet,**
   daß parallel zu den ersten Leiterabschnitten (19b, 19c) und dem zweiten Leiterabschnitt (19d) Abschirmleitungen (19i, 19k, 19l) angeordnet sind.

6. Oberflächenspule nach einem der Ansprüche 1 bis 5,
   **dadurch gekennzeichnet,**
   daß die Schalter (20 - 23) als PIN-Diodenschalter ausgeführt sind.

## Claims

1. A surface coil for a nuclear spin resonance apparatus for detecting spectra or images of an object under examination by means of nuclear magnetic resonance with coils (1, 2, 3, 4, 7, 8) for applying magnetic fundamental and gradient fields to the object under examination (5) and with an antenna (9), with which the object under examination (5) is irradiated with a sequence of radio frequency pulses, wherein the nuclear resonance signals emitted by the object under examination (5) are detected with the surface coil (19), which consists of several conductor sections (19b - 19h), and wherein the surface coil (19) is connected by way of a tuning unit (19a) to an evaluating circuit, characterised in that the conductor sections (19b - 19h) of the surface coil (19) are able to be connected by way of switches (20 - 23) to each other and to the tuning unit (19a), so that the conductor sections (19b - 19h) connected to the tuning unit (19a), depending on the position of the switches (20 - 23) enclose variable areas.

2. A surface coil according to claim 1, characterised in that the conductor sections (19b - 19h) enclose several connected rectangles.

3. A surface coil according to claim 2, characterised in that it consists of two first conductor sections (19b, 19c) arranged in a line, which are connected to a respective connector of the tuning unit (19a), in that parallel to both first conductor sections (19b, 19c) there is arranged a second conductor section (19d) and in that both first conductor sections (19b, 19c) are connected to the second conductor section (19d) by way of third conductor sections (19e - 19h), provided with switches and arranged parallel and spaced from each other.

4. A surface coil according to claim 1 or 2, characterised in that it has two first conductor sections (19b, 19c) parallel to each other, which are connected to a respective connector of the tuning unit (19a), in that parallel to both first conductor sections (19b, 19c) there is arranged a second conductor section (19d), in that between the first conductor sections (19b, 19c) and the second conductor sections (19b, 19c, 19d) there are provided third conductor sections (19e, 19h) arranged parallel and spaced from one another, which, on the one hand, are able to be connected by way of a respective switch (20 - 23) to the second conductor section (19d) and, on the other hand, by way of a transfer switch (24 - 27) selectively to one of the first conductor sections (19b, 19c).

5. A surface coil according to one of claims 1 to 4, characterised in · that parallel to the first conductor sections (19b, 19c) and the second conductor section there are arranged shielded leads (19i, 19k, 191).

6. A surface coil according to one of claims 1 to 5, characterised in that the switches (20 - 23) are designed as p-i-n-diode switches.

**Revendications**

1. Bobine de surface pour un appareil de résonance magnétique nucléaire servant à déterminer des spectres ou des images d'un objet à examiner à l'aide de la résonance magnétique nucléaire, comportant des bobines (1,2,3,4,7,8) servant à appliquer un champ magnétique de base ou des champs magnétiques irrotationnels à l'objet à examiner (5), et une antenne (9) au moyen de laquelle l'objet à examiner (5) est irradié par une suite d'impulsions à haute fréquence, et dans laquelle les signaux de résonance nucléaire émis par l'objet à examiner (5) sont détectés au moyen de la bobine de surface (19) constituée par plusieurs sections de conducteurs (19b-19h), cette bobine étant raccordée par l'intermédiaire d'une unité de réglage d'accord (19a) à un circuit d'évaluation, caractérisée par le fait que les sections de conducteurs (19b-19h) de la bobine de surface (19) peuvent être raccordées par l'intermédiaire d'interrupteurs (20-23) entre elles et à l'unité de réglage d'accord (19a) de manière que les sections de conducteurs (19b-19h), qui sont raccordées à l'unité de réglage d'accord (19a) en fonction de la position des interrupteurs (20-23), enserrent des surfaces différentes.

2. Bobine de surface suivant la revendication 1, caractérisée par le fait que les sections de conducteurs (19b-19h) enserrent plusieurs rectangles contigus.

3. Bobine de surface suivant la revendication 2, caractérisée par le fait qu'elle est constituée par deux premières sections de conducteurs (19b,19c) qui sont disposées suivant une ligne et sont raccordées à une borne respective de l'unité de réglage d'accord (19a), qu'une seconde section de conducteur (19e) est branchée en parallèle avec les deux premières sections de conducteurs (19b,19c), et que les deux premières sections de conducteurs (19b,19c) sont reliées à la seconde section de conducteurs (19d) par l'intermédiaire de troisièmes sections de conducteurs (19e-19h) comportant des interrupteurs et disposées en parallèle et à distance les unes des autres.

4. Bobine de surface suivant la revendication 1 ou 2, caractérisée par le fait qu'elle comporte deux premières sections de conducteurs (19b,19c), parallèles entre elles, qui sont raccordées respectivement à une borne de l'unité de réglage d'accord (19a), qu'une seconde section de conducteur (19d) est branchée en parallèle avec les deux premières sections de conducteurs (19b,19c), qu'entre les premières sections de conducteurs (19b,19c) et la seconde section de conducteur (19d) sont disposées des troisièmes sections de conducteurs (19e-19h) disposées parallèlement et à distance les unes des autres et pouvant être raccordées d'une part par l'intermédiaire d'un interrupteur respectif (20-23) à la seconde section de conducteur (19d) et d'autre part par l'intermédiaire d'un commutateur respectif (24-27) au choix à l'une des premières sections de conducteurs (19b,19c).

5. Bobine de surface suivant l'une des revendications 1 à 4, caractérisée par le fait que des conducteurs de blindage (19i,19k,19n) sont disposés parallèlement aux premières sections de conducteurs (19b,19c) et à la seconde section de conducteur (19d).

6. Bobine de surface suivant l'une des revendications 1 à 5, caractérisée par le fait que les interrupteurs (20-23) sont réalisés sous la forme d'interrupteurs à diodes PIN.

FIG 1

FIG 2

FIG 3